(19) Europäisches Patentamt
European Patent Office
Office européen des brevets

(11) **EP 4 019 663 A1**

(12) # EUROPEAN PATENT APPLICATION

(43) Date of publication:
**29.06.2022 Bulletin 2022/26**

(21) Application number: **20383152.4**

(22) Date of filing: **23.12.2020**

(51) International Patent Classification (IPC):
**C23C 14/14** (2006.01)    **C23C 14/26** (2006.01)
**C23C 14/28** (2006.01)    **C23C 14/30** (2006.01)
**C23C 14/32** (2006.01)

(52) Cooperative Patent Classification (CPC):
**C23C 14/26; C23C 14/14; C23C 14/28; C23C 14/30**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Advanced Nanotechonologies, S.L.**
 08028 Barcelona (ES)
• **Universitat de Barcelona**
 08028 Barcelona (ES)

(72) Inventors:
• **Bertran Serra, Enric**
 08028 BARCELONA (ES)
• **Bertran González, Enric Manuel**
 08028 BARCELONA (ES)
• **Domingo Risco, Sergi**
 08028 BARCELONA (ES)

(74) Representative: **Balder IP Law, S.L.**
 **Paseo de la Castellana 93**
 **5a planta**
 **28046 Madrid (ES)**

(54) ## INSTALLATION FOR DEPOSITING NANOSTRUCTURES ON A SUBSTRATE

(57) The present invention relates to an installation for depositing nanostructures on a receptor substrate SR, comprising a chamber C, vacuum generating means in the chamber C, one or more receptor substrates SR arranged in the chamber C, and a precursor target T arranged in the chamber C provided with a substrate S and at least one layer 1 of material to be deposited on the receptor substrates SR arranged on the substrate S of the target T, so that an interface IS1 is defined between the substrate S of the target T and the layer 1 of material to be deposited, comprising heating means for heating the substrate S of the target T, the heating means being configured to heat at least the interface IS1 between the substrate S and the layer 1 to the boiling temperature Teb1 of the material of the substrate, so that the vapour of the material of the substrate S generated on the interface IS1 causes the entrainment of nanostructures of the layer 1 intended to be deposited on the receptor substrate(s).

EP 4 019 663 A1

## Description

## TECHNICAL SECTOR

The invention relates to an installation for depositing nanostructures, to a consumable to be used in the installation and to a method for depositing nanostructures.

## BACKGROUND

Methods are known for depositing atoms or nanostructures on receptor substrates using vacuum (or near vacuum) chambers through which these atoms or nanostructures, which come from consumables, travel. These consumables are bombarded with particles or irradiated to cause their evaporation and then be deposited at high speed on receptor substrates.

One deposition material used is tungsten, which is a material that has a very high boiling temperature. One way to deposit this material is by sputtering. That being said, the use of this technique puts limitations on the way in which this material can be deposited. It can be deposited in atomic form by sputtering.

However, in some applications it is desired to deposit tungsten in the form of nanostructures, in other words, aggregates of atoms of the order of 1 to 10 nanometres, at high speeds so that they are sufficiently well adhered to the receptor substrate.

Currently, there is no low-cost method that is scalable at the industrial level and which makes it possible to deposit tungsten in the form of nanoparticles, or other materials with such a high boiling temperature.

## DESCRIPTION OF THE INVENTION

To overcome the drawbacks of the state of the art, a first aspect of the present invention proposes an installation for depositing nanostructures on a receptor substrate, comprising a chamber, means of generating vacuum in the chamber, one or more receptor substrates arranged in the chamber, and a precursor target arranged in the chamber provided with a substrate and at least one layer of material to be deposited on the receptor substrates arranged on the substrate of the target, so that an interface is defined between the substrate of the target and the layer of material to be deposited, comprising means for heating the substrate of the target, the heating means being configured to heat at least the interface between the substrate and the layer to the boiling temperature of the material of the substrate, so that the vapour of the material of the substrate generated at the interface causes the entrainment of nanostructures of the layer intended to be deposited on the receptor substrate(s).

Therefore, the invention consists of acting on the substrate of the consumable target, rather than acting directly on the interface of the deposition material with the substrate. In other words, according to the invention, energy is supplied to the interface between substrate and deposition material, the material of the substrate evaporates and it entrains the deposition material. The inventors have verified that the size of the aggregates of deposition material that is entrained varies and it includes both atomic-sized material and nano-sized aggregates.

In some embodiments, the means for heating the interface are:

- by the Joule effect by means of a rear electrical conductor attached to the substrate, and/or
- by incident radiation from the front portion of the layer, and/or
- by bombardment of particles from the front portion of the layer.

In some of the preceding embodiments, the front portion of the layer is uncovered.

In some embodiments, the substrate comprises several layers arranged on the substrate.

In some embodiments, the substrate is a material with a low coefficient of thermal expansion and low thermal conductivity.

In some embodiments, the substrate of the target is a ceramic material.

In some embodiments, the substrate of the target is $SiO_2$.

In some embodiments, the layer is made of tungsten.

In some embodiments, the thickness of the layer is comprised between 5 and 2,000, i.e., two thousand, nm, and it is preferably 60 nm.

In some embodiments, the heating means are by the Joule effect and consist of a refractory metal resistance, preferably of (W, Mo, Ta, etc.), with current densities up to 15,000, i.e., fifteen thousand, $A/cm^2$.

In some of these embodiments, the power P dissipated in the conductive sheet that heats the target is:

$$P = \int_v j^2 \cdot \rho \cdot dv$$

where:

j is the surface current density that passes through the conductor,
$\rho$ is the electrical resistivity, and
v is the volume of the conductor.

In some of these embodiments, the sheet is a tungsten strip with a cross section of 0.15 mm x 20 mm and a length of 50 mm, with p = 5.60 x $10^{-8}$ $\Omega \cdot$m at 20°C, for a power of 5 kW, and the fact that the resistivity of tungsten varies with temperature is taken into account. At a power of 3.6 kW, the current density is $j$ = 13.3 kA/cm² (considered constant at all points of the conductive sheet), the temperature of the tungsten strip rises to 3400°C, close to tungsten's melting point of 3422°C.

In some embodiments, the current densities are up to 5,000, i.e., five thousand, $A/cm^2$. The power P dissipated in the conductive sheet, such as the refractory material resistance, which heats the target and considering that the current density is constant at all points of the conductive sheet, is:

$$P = j^2 \cdot \rho \cdot v$$

where:

$j$ is the surface current density that passes through the conductor,
$\rho$ is the resistivity, and
$v$ is the volume of the conductor.

In some of these embodiments, the sheet is a tungsten strip with a cross section of 0.15 mm x 20 mm and a length of 50 mm, with p = 5.60 x $10^{-8}$ Ω·m at 20°C, for a power of 5 kW, and the fact that the resistivity of tungsten varies with temperature is taken into account. At a power of 3.6 kW, the current density is $j$ = 13.3 $kA/cm^2$, the temperature of the tungsten strip rises to 3400°C, close to tungsten's melting point of 3422°C.

In some embodiments, the heating means are an electron gun, preferably of electrons with energy up to the order of 10 keV and electron beam power up to the order of 30 kW.

In some embodiments, the heating means are:

- a focussed electron beam generator; or
- a focussed laser generator (with or without scanning); or
- an ion beam generator.

A second aspect of the present invention proposes a method using a "physical vapour deposition" (PVD) technique for depositing nanostructures on receptor substrates, wherein an installation is used according to any of the preceding claims.

A third aspect of the present invention proposes a precursor target for an installation according to any of the preceding embodiments, comprising a ceramic material substrate, preferably $SiO_2$, and a layer of material to be deposited.

In some embodiments, the layer is made of tungsten.

In some embodiments, the substrate comprises several layers arranged on the substrate.

## BRIEF DESCRIPTION OF THE FIGURES

To complete the description and to provide a better understanding of the invention, a set of figures is included. Said figures form an integral part of the description and illustrate embodiments of the invention, which must not be interpreted as limiting the scope of the invention, but simply as an example of how the invention can be carried out. The drawings comprise the following figures:

Figure 1 shows a target according to an embodiment of the present invention.

Figure 2 shows a target according to an embodiment of the present invention.

Figure 3 shows an installation for depositing nanostructures on receptor substrates according to an embodiment of the present invention.

Figures 4 and 5 show diagrams of electron penetration in a target.

Figure 6 is a diagram that shows cathodoluminescence as a function of depth.

Figure 7 is a diagram that shows cathodoluminescence as a function of radius.

Figure 8 is a diagram that shows the temperature evolution of different layers of a target in an installation according to an embodiment of the present invention.

Figure 9 shows a target in an initial heating stage in an installation according to an embodiment of the present invention wherein the target is irradiated from above.

Figure 10 shows the target of Figure 9 in a more advanced heating stage.

Figure 11 shows the target of Figure 10 in a more advanced heating stage.

Figure 12 shows the target of Figure 11 in an evaporation stage of the substrate of the target.

Figure 13 shows a target and crucible according to an embodiment of the present invention, after the heating process, wherein the tungsten layer has been volatilised.

Figure 14 shows the target and the crucible of Figure 13 under heating.

Figure 15 shows the target according to an embodiment of the present invention, after the heating process, wherein the tungsten layer has been volatilised only in the portion that was directly heated from the rear portion, attached to the conductive sheet heated by the Joule effect.

Figure 16 shows a target in an initial heating stage in an installation according to an embodiment of the present invention wherein the target is irradiated from below.

Figure 17 shows the target of Figure 16 in a more advanced heating stage.

Figure 18 shows the target of Figure 17 in a more advanced heating stage.

Figure 19 shows the target of Figure 18 in an evaporation stage of the substrate of the target.

## DESCRIPTION OF PREFERRED EMBODIMENTS

### 1. General case

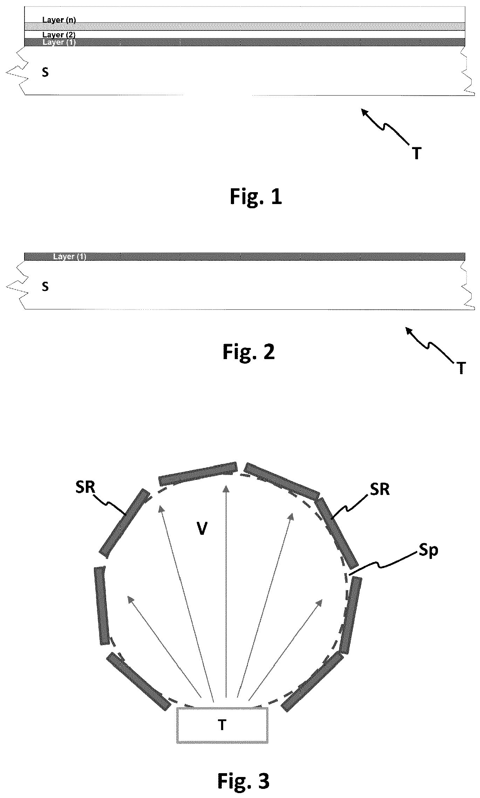

Figure 1 shows a precursor target T for an installation for depositing nanostructures on a receptor substrate. The target T is provided with a substrate S made of a material with a low coefficient of thermal expansion and low thermal conductivity, such as ceramic, and having several layers 1, 2, ... n stacked on top of the substrate.

Figure 2 shows a target T having a $SiO_2$ substrate S and a layer 1 of material to be deposited, such as tungsten, so that an interface IS1 is defined between the substrate S of the target T and the layer 1 of material to be deposited. The thickness of the layer 1 is 60 nm.

Figure 3 shows an installation for depositing nanostructures on a receptor substrate SR. The installation comprises a chamber C with a volume V, means of generation of vacuum in the chamber C (which can have a spherical or cylindrical shape Sp) and one or more receptor substrates SR arranged in the chamber C. A precursor target T is arranged in the chamber C provided with a substrate S and a layer 1 of material to be deposited on the receptor substrates SR arranged on the substrate S of the target T.

The installation comprises heating means for heating the substrate S of the target T configured to heat at least the interface IS1 between the substrate S and the layer 1 to the boiling temperature Teb1 of the material of the substrate, such that the vapour of the material of the substrate S generated on the interface IS1 causes the entrainment of nanostructures of the layer 1 intended to be deposited on the receptor substrate(s). The entrainment of the nanostructures has been represented with arrows starting at the target T and ending at the receptor substrates SR.

Thus, the installation for depositing nanostructures enables nanostructures to be deposited on receptor substrates SR through physical vapour deposition (PVD).

To heat the interface, the following heating means can be used:

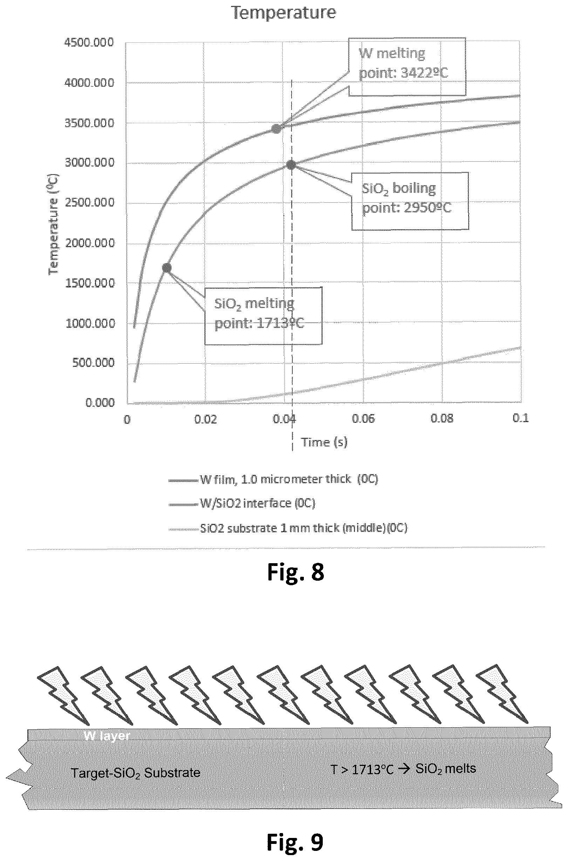

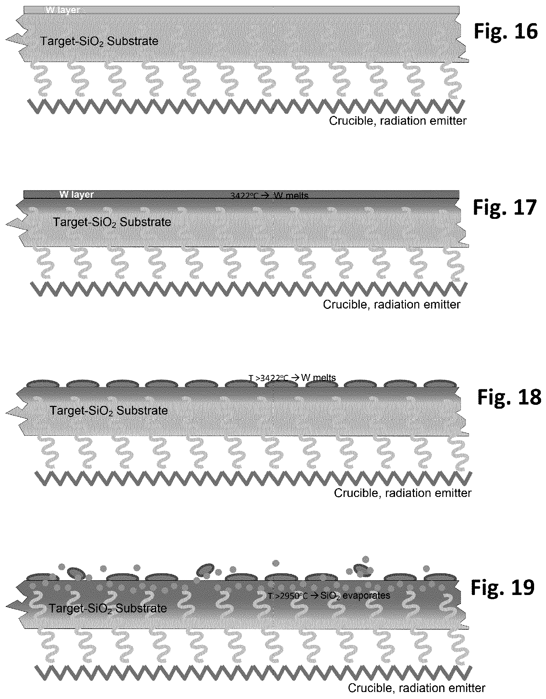

- by the Joule effect J by means of a rear electrical conductor CJ attached to the substrate S, as shown in Figures 16 to 19,
- by incident radiation IR from the front portion of the layer 1, as shown in Figures 9 to 12 and
- by bombardment G of particles from the front portion of the layer 1, as shown in Figures 9 to 12.

In heating by the Joule effect J, a refractory metal resistance can be used, preferably of W, Mo, Ta, with current densities up to 15,000, i.e., fifteen thousand, $A/cm^2$.

The heating means can include an electron gun, preferably of electrons with energy up to the order of 10 keV and electron beam power up to the order of 30 kW.

The heating means can include:

- a focussed electron beam generator; or
- a focussed laser generator; or
- an ion beam generator.

### 2. Implementation of the invention by providing heat with electron bombardment

The simplest case of a target formed by a layer of material on the substrate, as shown in Figure 2, will be described below, bombarded with an electron beam which can take place by incident radiation IR from the front portion of the layer 1, and/or by bombardment G of particles from the front portion of the layer 1.

Electron bombardment provides local heating on the first layer 1 due to the absorption of the electrons at a depth less than the thickness of that layer 1.

According to a preferred embodiment, illustrated in Figure 3, the installation comprises a spherical volume V, vacuum generating means in the volume V, one or more receptor substrates SR arranged according to a spherical distribution, an electron gun G, and a target T like the one in Figure 1.

To illustrate the effectiveness of the target and the installation of the invention, simulations have been carried out with the CASINO programme using the following parameters:

Bombardment means (G):

- Power associated with the beam (approximately 100 W)
- Energy of the electrons (typically 5 keV)
- Electron current (approximately 20 mA)
- Electron flow (approximately 1.25 x $10^{17}$ electrons/s)

Parameters of the material of the thin sheet (W) that forms the layer 1:

- Density of W: 19.3 $g/cm^3$
- Thermal expansion of W: 4.5 pm/(m·K) (at 25°C)
- Thermal conductivity of W: 173 W/(m K)
- Melting point of W: 3422°C
- Evaporation point of W: 5930°C
- Specific heat of W: 132 J/(kg·K)
- Molar heat capacity of W: 24.27 J/(mol·K)
- Latent heat of W: 52.31 kJ/mol
- Vaporisation heat of W: 774 kJ/mol
- Mass of W in the target (1 $mm^3$ = 1600 nm thickness x 6.25 $cm^2$ surface area): 0.0193 g
- Atomic mass of W: 183.84 amu
- No. of moles of W: 1.05 x $10^{-4}$ mol
- Heat needed to evaporate W of the target: 976.250 kJ/mol, i.e., 102.5 J
- Time required to absorb this energy at 100 W, approximately 1.025 s

Parameters that characterise the substrate of the target (amorphous $SiO_2$):

- Density of amorphous $SiO_2$: 2.196 g/cm3
- Melting point of amorphous $SiO_2$: 1713°C
- Evaporation point of amorphous $SiO_2$: 2950°C
- Thermal expansion of amorphous $SiO_2$: 4.7 pm/(m·K) (at 25°C)
- Thermal conductivity of amorphous $SiO_2$: 1.4 W/(m K)
- Specific heat of amorphous $SiO_2$: 740 J/(kg-K)
- Molar heat capacity of amorphous $SiO_2$: 44.46 J/(mol·K)
- Latent heat of amorphous $SiO_2$: 27.46 kJ/mol
- Vaporisation heat of amorphous $SiO_2$: 228.03 kJ/mol
- Mass of amorphous $SiO_2$ in the target (625 mm$^3$ = 1 mm thickness x 6.25 cm$^2$ surface area): 1.3725 g
- Molecular mass of amorphous $SiO_2$: 60.08 g
- No. of moles of amorphous $SiO_2$: $2.284 \times 10^{-2}$ moles
- Heat required to melt amorphous $SiO_2$ of the target: 75.048 kJ/mol, i.e., 1714 J

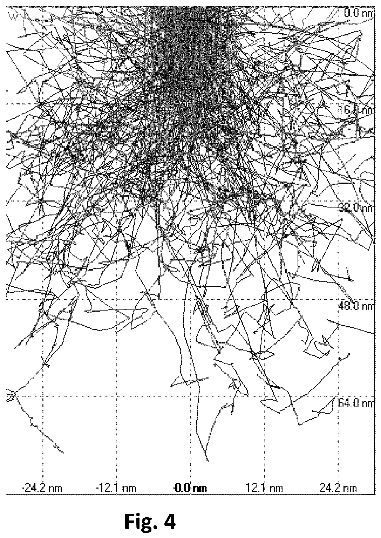

With these parameters, the following results have been obtained which are illustrated below with the aid of Figures 4 to 7.

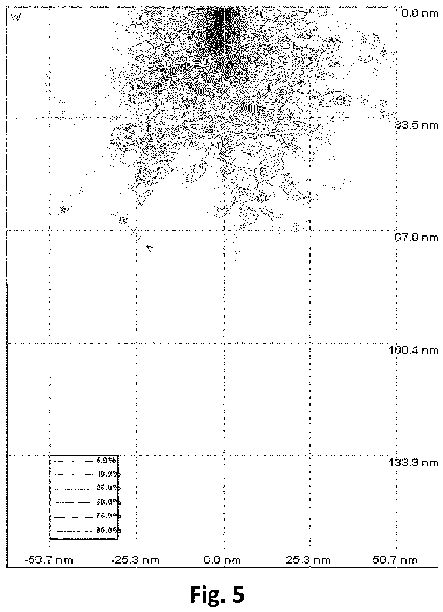

Figure 4 shows the results of electron penetration depth (obtained by the Monte Carlo method) when the electrons have an energy of 5 keV. It is observed that the electrons mainly penetrate about 30 nm and the energy thereof is dissipated in a small volume of about $3 \times 10^4$ nm$^3$. In the simulation illustrated in Figure 5, which shows energy distribution, the penetration volume is observed in more detail.

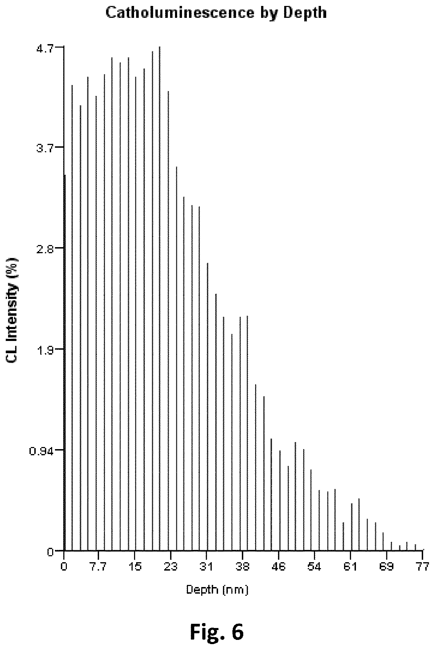

Figure 6 shows the percentage of electrons absorbed at different penetration depths. This shows the region where energy dissipation occurs and therefore temperature increases, which mainly corresponds to a depth of about 30 nm.

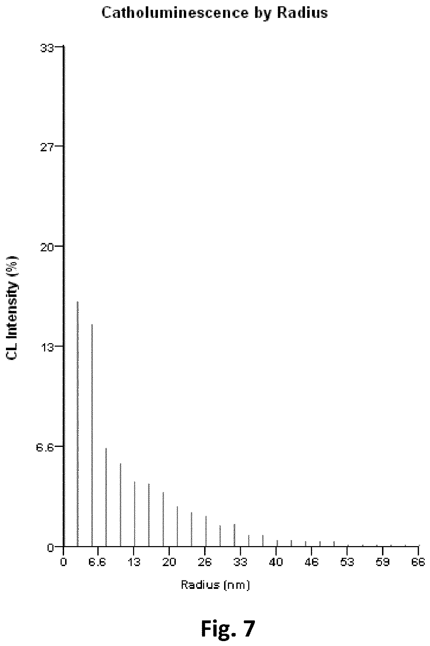

The radial distribution of electrons is shown in Figure 7, corresponding to an electron beam with a radius of 10 nm. It is observed that a third of the electrons are concentrated in a radius of 1 to 2 nm, centred on the electron beam.

Next, it is analytically shown that the invention enables the objectives sought to be achieved.

According to Fourier's law of heat transfer:

$$\frac{\partial Q}{\partial t} = -k_W A \vec{\nabla} T$$

and by calculating for a one-dimensional model of the target, made up of a 1 μm layer of tungsten on a 1 mm thick amorphous silica substrate, W/$SiO_2$, the temperature on the W layer and on the W/$SiO_2$ interface can be determined. The result of the evolution of temperature over time is shown in the graph of Figure 8. The following is observed:

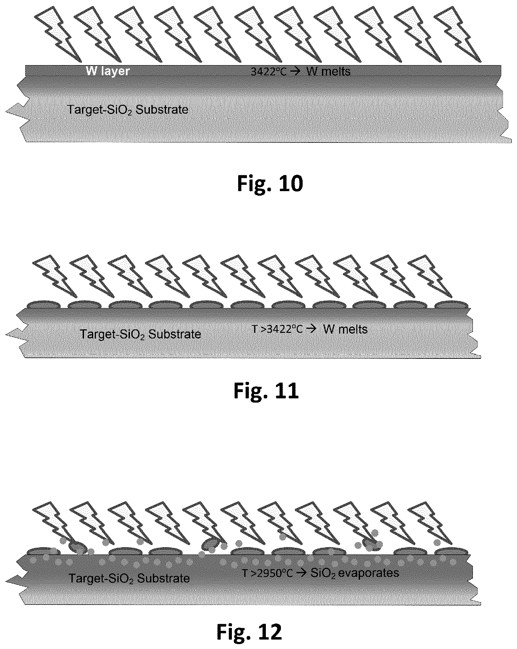

- As shown in Figure 9, about 10 ms after heating the system with electron bombardment on the W layer, the interface of the substrate begins to melt (starting at 1713°C).
- As shown in Figure 10, about 40 ms after bombardment starts, the W layer begins to melt (starting at 3,422°C measured in the centre of the W layer).
- As shown in Figure 12, 2 ms after W starts to melt, the temperature of $SiO_2$, close to the W/$SiO_2$ interface, reaches the evaporation temperature (2950°C) and $SiO_2$ begins to vaporise.

From this simulation, it follows that at the instant that the W layer melts, nucleation occurs on the surface due to the high surface energy of W and the high surface diffusion, thus giving rise to the formation of W nanoparticles on the molten $SiO_2$. Next, upon reaching the evaporation temperature of $SiO_2$, a strong ejection of the vapours occurs which entrains the W nanoparticles, which are projected on the substrates located at a great distance in the vacuum chamber as illustrated in Figure 12.

It is important to note that W does not reach the evaporation temperature (5930°C), which is higher than the temperature that can be reached with electron bombardment. However, as the thin W layer melts, it does crack to form the nanoparticles and clusters. And they will be driven by the $SiO_2$ vapours in order to be deposited on the substrates of the vacuum chamber.

The W layer is heated due to intense electron bombardment and, as is common in the electron gun evaporation technique for achieving a uniform temperature on the surface of the target, the electron beam sweeps the target directed by the Lorentz force, created by the interaction with a magnetic field that oscillates in the XY plane parallel to the horizontal plane of the target.

The sequence of Figures 9 to 12 shows the different stages of the mechanism for forming and projecting the W clusters.

## 3. Implementation by means of heating a plate attached to the substrate by the Joule effect

An embodiment is defined below wherein heating means for heating the interface IS1 of the target by the Joule effect J are used by means of a rear electrical conductor CJ attached to the substrate S, illustrated in Figures 16 to 19.

It is important to note that W does not reach the evaporation temperature (5930°C), which is higher than the temperature that can be reached with blackbody radiation heating of the crucible. However, the thin W layer can reach its melting temperature before $SiO_2$ melts because the metallic layer absorbs the radiation that passes through the $SiO_2$ substrate, which has low absorption of radiation at the wavelengths emitted by the crucible (UV, VIS, NIR). In that heating sequence, as the W layer exceeds its melting temperature, it cracks to form the nanoparticles and clusters. The $W/SiO_2$ interface is heated by transferring heat from the metallic W layer, and when it reaches the boiling point, the $SiO_2$ vapours increase the pressure on the interface and it drives the W clusters and nanoparticles as the cohesive forces that held them on the surface of the target are overcome. The nanoparticles and clusters are thus projected by the $SiO_2$ vapours that appear on the $W/SiO_2$ interface in order to be deposited on the receptor substrates of the vacuum chamber.

The W layer is heated due to the intense radiation emitted by the crucible and the strong absorption of that radiation by part of the metal layer.

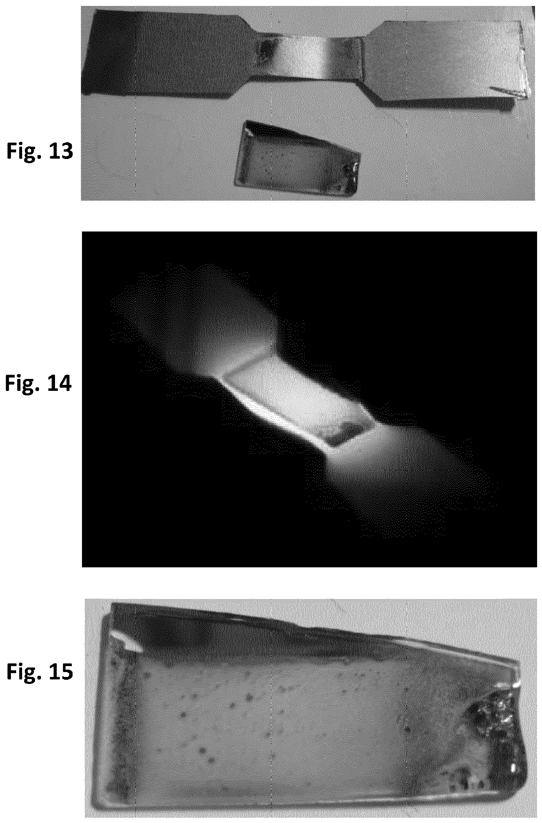

Figure 13 shows an electrically conductive band and a target provided with a $SiO_2$ substrate and a layer of tungsten. Figure 13 shows that the target is slightly wider than the central portion of the band; specifically, the measurements of the target are 25 mm x 12-15 mm x 1.5 mm (with a right-angled trapezium shape). The refractory metal band-crucible was 12 mm wide.

Figure 14 shows heating by the Joule effect at 260 A of the $W/SiO_2$ target placed on the refractory metal band. The electrical power for heating the crucible is of the order of 2 kW. The temperature of the band, or crucible, was very high so that the $W/SiO_2$ interface of the target could evaporate, after the W layer had cracked as the $SiO_2$ melted. $SiO_2$ evaporation drives the nanoparticles formed from the W layer which are projected towards the vacuum chamber.

In Figure 15, the target can be seen according to an embodiment of the present invention, after the heating process, wherein the tungsten layer has been volatilised only in the portion that was directly heated from the rear portion, attached to the conductive sheet heated by the Joule effect.

In this text, the term "comprises" and its derivations (such as "comprising", etc.) should not be understood in an excluding sense, in other words, these terms should not be interpreted as excluding the possibility that what is described and defined may include other elements.

The invention is obviously not limited to the specific embodiments described herein, but rather encompasses any variation that any person skilled in the art could consider to fall within the general scope of the invention as defined in the claims.

**Claims**

1. An installation for depositing nanostructures on a receptor substrate (SR), comprising a chamber (C), vacuum generating means in the chamber (C), one or more receptor substrates (SR) arranged in the chamber (C), and a precursor target (T) arranged in the chamber (C) provided with a substrate (S) and at least one layer (1) of material to be deposited on the receptor substrates (SR) arranged on the substrate (S) of the target (T), so that an interface (IS1) is defined between the substrate (S) of the target (T) and the layer (1) of material to be deposited, **characterised in that** it comprises heating means for heating the substrate (S) of the target (T), the heating means being configured to heat at least the interface (IS1) between the substrate (S) and the layer (1) to the boiling temperature (Teb1) of the material of the substrate, such that the vapour of the material of the substrate (S) generated on the interface (IS1) causes the entrainment of nanostructures of the layer (1) intended to be deposited on the receptor substrate(s).

2. The installation according to claim 1, wherein the heating means for heating the interface (IS1) are:

   - by the Joule effect (J) by means of a rear electrical conductor (CJ) attached to the substrate (S), and/or
   - by incident radiation (IR) from the front portion of the layer (1), and/or
   - by bombardment (G) of particles from the front portion of the layer (1).

3. The installation according to any of the preceding claims, wherein the substrate (S) comprises several layers (1, 2, ..., n) arranged on the substrate (S).

4. The installation according to any of the preceding claims, wherein the substrate (S) is a material with a low coefficient of thermal expansion and low thermal conductivity.

5. The installation according to any of the preceding claims, wherein the substrate (S) of the target (T) is a ceramic material.

6. The installation according to any of the preceding claims, wherein the substrate (S) of the target (T) is $SiO_2$.

7. The installation according to any of the preceding claims, wherein the layer (1) is made of tungsten (W).

8. The installation according to claim 7, wherein the thickness of the layer (1) is comprised between 5 and 2,000 (two thousand) nm, and it is preferably 60 nm.

9. The installation according to claim 1, wherein the heating means are by the Joule effect (J) and consist of a refractory metal resistance, preferably of (W, Mo, Ta, etc.), with current densities up to 15,000 (fifteen thousand) $A/cm^2$.

**10.** The installation according to claim 1, wherein the heating means are an electron gun, preferably of electrons with energy up to the order of 10 keV and electron beam power up to the order of 30 kW.

**11.** The installation according to claim 1, wherein the heating means are:

- a focussed electron beam generator; or
- a focussed laser generator; or
- an ion beam generator.

**12.** A method using a PVD technique for depositing nanostructures on receptor targets (SR), wherein an installation is used according to any of the preceding claims.

**13.** A precursor target (T) for an installation according to any of claims 1 to 11, comprising a ceramic material substrate, preferably $SiO_2$, and a layer (1) of material to be deposited.

**14.** The precursor target (T) according to claim 13, wherein the layer (1) is made of tungsten (W).

**15.** The target (T) according to claim 14, wherein the substrate (S) comprises several layers (1, 2, ..., n) arranged on the substrate (S).

Layer (n)
Layer (2)
Layer (1)

S

T

**Fig. 1**

Layer (1)

S

T

**Fig. 2**

SR
SR
V
Sp
T

**Fig. 3**

**Fig. 4**

**Fig. 5**

Fig. 6

Fig. 7

Temperature

**Fig. 8**

**Fig. 9**

**Fig. 10**

W layer      3422°C → W melts

Target-SiO$_2$ Substrate

**Fig. 11**

Target-SiO$_2$ Substrate      T >3422°C → W melts

**Fig. 12**

Target-SiO$_2$ Substrate      T >2950°C → SiO$_2$ evaporates

Fig. 13

Fig. 14

Fig. 15

W layer

Target-SiO$_2$ Substrate

Crucible, radiation emitter

**Fig. 16**

W layer          3422°C → W melts

Target-SiO$_2$ Substrate

Crucible, radiation emitter

**Fig. 17**

T >3422°C → W melts

Target-SiO$_2$ Substrate

Crucible, radiation emitter

**Fig. 18**

T >2950°C → SiO$_2$ evaporates

Target-SiO$_2$ Substrate

Crucible, radiation emitter

**Fig. 19**

Europäisches
Patentamt

European
Patent Office

Office européen
des brevets

## EUROPEAN SEARCH REPORT

Application Number

EP 20 38 3152

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GB 2 574 220 A (SUMITOMO CHEMICAL CO [JP]) 4 December 2019 (2019-12-04) * claims 1-14; figure 1 * | 1-15 | INV. C23C14/14 C23C14/26 C23C14/28 C23C14/30 C23C14/32 |
| A | EP 3 279 365 A1 (ADVANCED NANOTECHONOLOGIES S L [ES]) 7 February 2018 (2018-02-07) * claims 1-20 * | 1-15 | |
| A | US 2013/011440 A1 (HERBST FRANZ [DE] ET AL) 10 January 2013 (2013-01-10) * claims 1-22 * | 1-15 | |
| A | CA 885 623 A (LANASPEZE PIERRE; TANNENBERGER HELMUT) 9 November 1971 (1971-11-09) * claims 1-14; figure 1; examples 1,2 * | 1-15 | |

TECHNICAL FIELDS
SEARCHED     (IPC)

C23C

The present search report has been drawn up for all claims

| Place of search | Date of completion of the search | Examiner |
|---|---|---|
| The Hague | 8 June 2021 | Battistig, Marcello |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 38 3152

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2021

| Patent document cited in search report | | | Publication date | Patent family member(s) | | Publication date |
|---|---|---|---|---|---|---|
| GB 2574220 | A | | 04-12-2019 | NONE | | |
| EP 3279365 | A1 | | 07-02-2018 | EP | 3279365 A1 | 07-02-2018 |
| | | | | ES | 2584961 A1 | 30-09-2016 |
| | | | | US | 2018073133 A1 | 15-03-2018 |
| | | | | WO | 2016156649 A1 | 06-10-2016 |
| US 2013011440 | A1 | | 10-01-2013 | US | 2013011440 A1 | 10-01-2013 |
| | | | | WO | 2011000357 A2 | 06-01-2011 |
| CA 885623 | A | | 09-11-1971 | NONE | | |

EPO FORM P0459

For more details about this annex : see Official Journal of the European Patent Office, No. 12/82